# EUROPEAN PATENT SPECIFICATION

(11) **EP 1 119 030 B1**
(45) Date of publication and mention of the grant of the patent: **02.05.2007**
(21) Application number: 99943304.8
(22) Date of filing: 13.09.1999
(51) Int. Cl.: H01L 21/205, C23C 16/44

(54) **PLASMA REACTOR**
PLASMAREAKTOR
REACTEUR AU PLASMA

(30) Priority: 14.09.1998 JP 27936898
(43) Date of publication of application: 25.07.2001
(73) Proprietor: TOKYO ELECTRON LIMITED, Minato-ku, Tokyo 107-8481 (JP)
(72) Inventor: OKA, Shinsuke, Sagamihara-shi, Kanagawa 229-1103 (JP); NAKASE, Risa, Sagamihara-shi, Kanagawa 229-0031 (JP); AKAHORI, Takashi, Hachioji-shi, Tokyo 192-0362 (JP); KAWAKAMI, Satoru, Sagamihara-shi, Kanagawa 228-0814 (JP)
(74) Representative: Liesegang, Eva
(86) International application number: PCT/JP1999/004980
(87) International publication number: WO 2000/016385

(56) References cited:
- EP-A- 0 658 918
- WO-A-96/15545
- JP-A- 4 000 390
- JP-A- 9 022 875
- JP-U- 4 007 658
- PATENT ABSTRACTS OF JAPAN vol. 1995, no. 07, 31 August 1995 (1995-08-31) -& JP 07 099160 A (NIPPON TELEGR & TELEPH CORP), 11 April 1995 (1995-04-11)
- PATENT ABSTRACTS OF JAPAN vol. 012, no. 405 (C-539), 26 October 1988 (1988-10-26) & JP 63 143273 A (ANELVA CORP), 15 June 1988 (1988-06-15)
- PATENT ABSTRACTS OF JAPAN vol. 1995, no. 07, 31 August 1995 (1995-08-31) & JP 07 106307 A (MITSUBISHI ELECTRIC CORP), 21 April 1995 (1995-04-21)
- PATENT ABSTRACTS OF JAPAN vol. 017, no. 154 (C-1040), 26 March 1993 (1993-03-26) -& JP 04 318175 A (SONY CORP), 9 November 1992 (1992-11-09)

## Description

### TECHNICAL FIELD

The present invention relates generally to a plasma processing method for processing substrates, such as semiconductor wafers, with plasma.

### BACKGROUND ART

A typical semiconductor device producing process includes a thin-film deposition process and/or an etching process for semiconductor wafers (which will be hereinafter referred to as "wafers") by utilizing plasma. This process is carried out by introducing a process gas into a vacuum vessel having a wafer supporting-table and by supplying, e.g. electromagnetic energy, to the process gas to produce plasma.

As techniques for producing plasma by electromagnetic energy, there are known a method utilizing the ECR (Electron Cyclotron Resonance) which is the interaction between microwaves and magnetic fields, and the ICP (Inductive Coupled Plasma) utilizing induction fields produced by a high-frequency induction field.

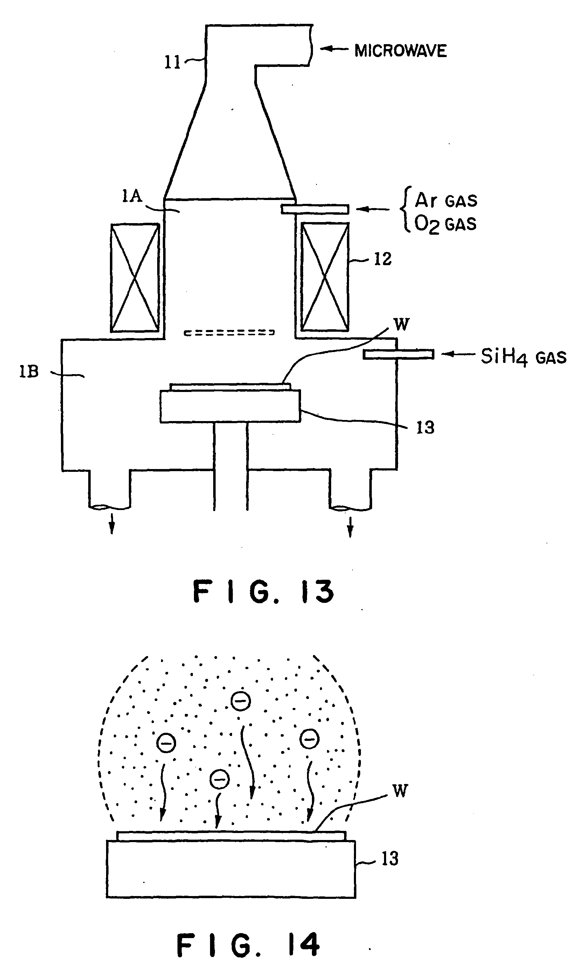

Referring to FIG. 13, as an example of a conventional plasma processing system for plasma-processing by the ECR, an example of a thin-film deposition process will be described below.

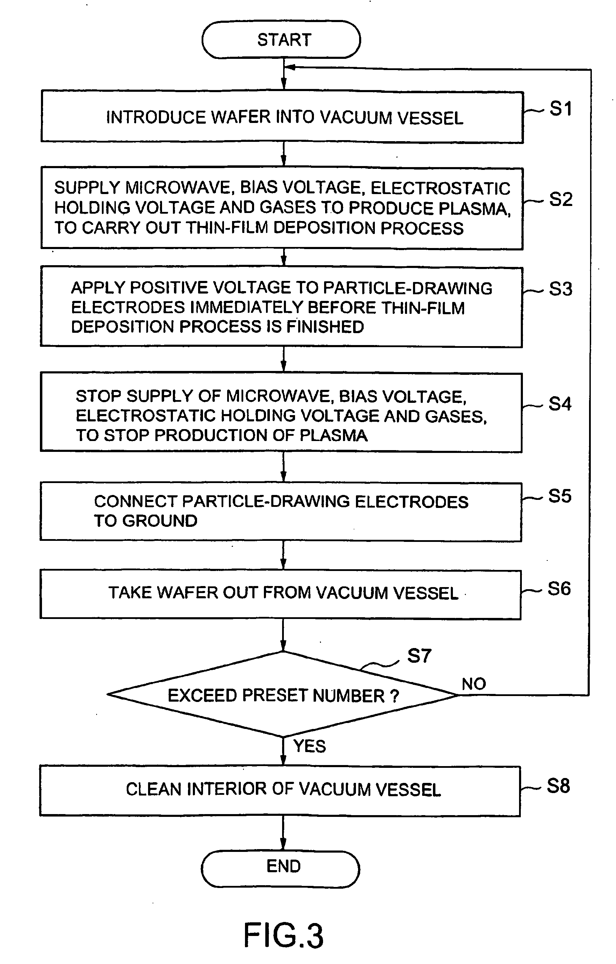

In FIG. 13, a microwave of, e.g. 2.45 GHz, is supplied to a plasma producing chamber 1A via a waveguide 11. Simultaneously, a magnetic field is applied by an electromagnetic coil 12 so that the intensity of magnetic field is, e.g. 875 gausses, on the dotted line in FIG. 3. By the interaction (resonance) between the microwave and the magnetic field, the high-density plasma of plasma producing gases, e.g. Ar and O₂ gases, is produced. This plasma activates a reactive gas, e.g. SiH₄ gas, which has been introduced into a deposition chamber 1B, to form active species (radicals). This active species simultaneously carries out the sputter etching and deposition on a wafer W on a supporting-table 13.

Although the high-density plasma rises in a region facing the wafer W, a low-density plasma exists in the whole vacuum vessel. This low-density plasma sometimes deteriorates an O-ring, which is a sealing member for the vacuum vessel, or the like, or causes a film, which has adhered to the wall of the vessel by the reaction of process gases, to be removed. Thus, it is impossible to avoid the production of particles in the vacuum vessel.

While plasma is produced, particles are confined in the plasma since plasma is conductive. However, when the production of plasma is stopped, the particles in the plasma drop to adhere to the wafer W as shown in FIG. 14. In particular, when the supporting-table is provided with an electrostatic chuck for holding the wafer W, the wafer W is easily charged, so that the particles are attracted to the wafer W. However, such adhesion of particles to the wafer must be inhibited as greatly as possible, since the scale down of circuit patterns will increasingly proceed in future.

WO 96/15545 discloses a plasma processing system comprising a vacuum vessel and a supporting table, provided in the vacuum vessel. A process gas is supplied to the vacuum vessel to produce a plasma; a particle-drawing electrode is provided in the vacuum vessel; and a voltage supplying means for applying a voltage to said electrode is provided as well. Similar prior art is shown in JP 63 143273 A and JP 07 099160 A.

### DISCLOSURE OF THE INVENTION

The present invention has been made in the above described circumstances, and it is an object of the present invention to provide a plasma processing method capable of inhibiting the adhesion of particles to a substrate and improving yields.

The present invention provides a method of processing a substrate according to claim 1. The preferred embodiments of the method are defined in dependent claims 2 to 7.

The method according to the present invention is performed in a plasma processing system comprising a vacuum vessel and a supporting-table, provided in the vacuum vessel, for supporting thereon a substrate, wherein a process gas is supplied to the vacuum vessel to produce a plasma of the process gas to carry out a process with respect to the substrate, which is supported on the supporting-table, with the plasma of the process gas, the plasma processing system further comprising: a particle-drawing electrode provided in the vacuum vessel; and voltage applying means for applying a voltage to the electrode, wherein the voltage is applied to the particle-drawing electrode by the voltage applying means when the production of the plasma is stopped.

According to this plasma processing method, charged particles can be drawn into the particle-drawing electrode by applying the voltage to the particle-drawing electrode by the voltage applying means when the production of plasma is stopped. Thus, when the plasma process is carried out with respect to the substrate, it is possible to inhibit particles from adhering to the substrate, so that it is possible to improve yields.

The plasma processing system used may further comprise a supporting-table surrounding body provided so as to surround the supporting-table. This surrounding body has a surface arranged around a supporting face of the supporting-table, and the particle-drawing electrode is provided near the surface of the surrounding body.

According to this plasma processing method, it is possible to draw particles around the supporting-table. It is also possible to inhibit the adhesion of a reaction product, which causes the production of particles, around the supporting-table, so that it is possible to improve the cleaning efficiency for removing the reaction product.

In the above described plasma processing systems, the application of the voltage to the particle-drawing electrode may be started immediately before the production of the plasma is stopped. Thus, it is possible to efficiently draw particles, which drop when plasma disappears, into the particle-drawing electrode.

The voltage applying means may apply a positive voltage to the particle-drawing electrode. Thus, it is possible to draw negative-charged particles into the particle-drawing electrode.

The process carried out with respect to the substrate with the plasma may be a thin-film deposition process or an etching process.

According to the present invention, there should be provided a plasma processing system comprising: a vacuum vessel defining a first vacuum chamber for producing a plasma therein by utilizing a high frequency, and a second vacuum chamber communicated with the first vacuum chamber; high-frequency supply means for supplying the high frequency to the first vacuum chamber; process gas supply means for supplying a process gas to the second vacuum chamber; and a supporting-table, provided in the second vacuum chamber, for supporting thereon a substrate, wherein said plasma of the process gas is produced in the second vacuum chamber to carry out a process with respect to the substrate on the supporting-table with the plasma of the process gas, the plasma processing system further comprising: a particle-drawing electrode provided in the second vacuum chamber; and voltage applying means for applying a voltage to the electrode, wherein the voltage is applied to the particle-drawing electrode by the voltage applying means when the production of the plasma is stopped.

In this plasma producing, the process gas supply means may have a gas hole for jetting the process gas into the second vacuum chamber, and the particle-drawing electrode may be provided near the gas hole.

The plasma processing system used may also further comprise a supporting-table surrounding body provided so as to surround the supporting-table. This surrounding body has a surface arranged around a supporting face of the supporting-table, and the particle-drawing electrode is provided near the surface of the surrounding body.

In this plasma processing method, the application of the voltage to the particle-drawing electrode may be started immediately before the supply of the high frequency by the high-frequency supply means is stopped or when the supply of the process gas by the process gas supply means is stopped. Thus, it is possible to efficiently draw particles, which drop when plasma disappears, into the particle-drawing electrode.

Also in this case, the voltage applying means applies a positive voltage to the particle-drawing electrode. Thus, it is possible to draw negative-charged particles into the particle-drawing electrode.
FIG. 1 is a longitudinal section showing the whole construction of a preferred plasma processing system for use in the present invention;
FIG. 2 is a schematic diagram showing a principal part of the plasma processing system of FIG. 1;
FIG. 3 is a flow chart showing the flow of a process in the plasma processing system of FIG. 1;
FIG. 4 is an illustration showing the state that particles having been confined in plasma are attracted by an electrode;
FIG. 5 is an illustration showing that a ring body prevents a thin film from adhering to the periphery of a supporting-table;
FIG. 6 is a sectional view of another example of a supporting-table;
FIG. 7 is a further example of a supporting-table;
FIG. 8 is a plan view of the supporting-table of FIG. 7;
FIG. 9 is a graph showing the relationship between voltages, which are applied between electrodes of an electrostatic chuck, and wafer temperatures;
FIG. 10 is a graph showing the variation in thickness distribution with respect to wafer temperatures;
FIG. 11 is a plan view of another example of a supporting-table;
FIG. 12 is a plan view of a part of a further example of a supporting-table;
FIG. 13 is a longitudinal section of a conventional plasma processing system; and
FIG. 14 is an illustration showing the state that particles having been confined in plasma adhere to a wafer in the conventional plasma processing system.

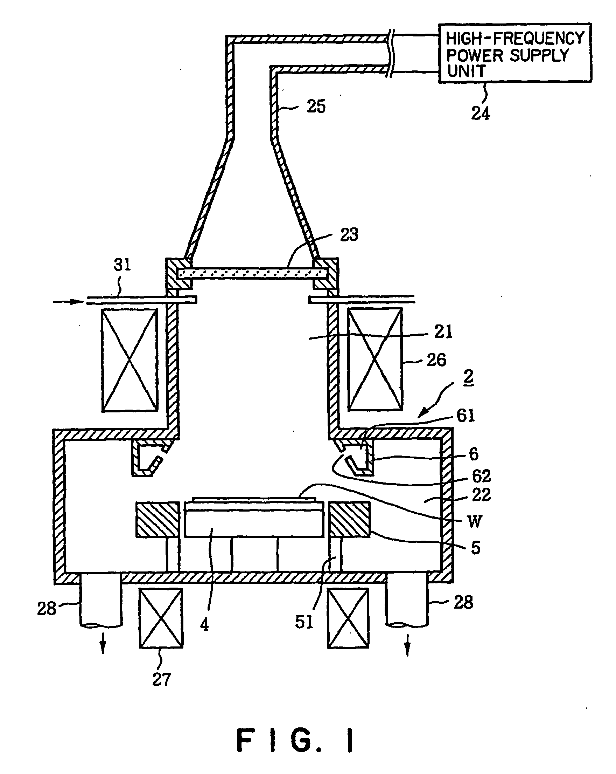

FIG. 1 schematically shows a preferred plasma processing system for use in the present invention. As shown in this figure, this plasma processing system has a vacuum vessel 2 of, e.g. aluminum. The vacuum vessel 2 comprises a first cylindrical vacuum chamber 21, arranged in the upper portion thereof, for producing plasma, and a second cylindrical vacuum chamber 22 which is communicated with the bottom of the first vacuum chamber 21. The vacuum vessel 2 is grounded to have zero potential.

The top end of the first vacuum chamber 21 of the vacuum vessel 2 is open. A transmission window 23 of a microwave transmittable material, e.g. quartz, is airtightly provided in the open top end so as to hold vacuum in the vacuum vessel 2. Outside of the transmission window 23, a waveguide 25 is provided. The waveguide 25 is connected to a high-frequency power supply unit 24 of, e.g. 2.45 GHz, which serves as a high-frequency supply means for plasma production. The waveguide 25 is designed to guide a microwave, which has been produced by the high-frequency power supply unit 24, in, e.g. a TE mode, or to convert a microwave, which has been guided in TE mode, into TM mode, to introduce the microwave from the transmission window 23 into the first vacuum chamber 21.

In the side wall defining the first vacuum chamber 21, gas nozzles 31 are arranged at regular intervals along, e.g. the periphery thereof. The gas nozzles 31 are connected to gas sources (not shown), e.g. an Ar gas source and an O₂ gas source, so that Ar gas and O₂ gas can be uniformly supplied to the upper portion in the first vacuum chamber 21.

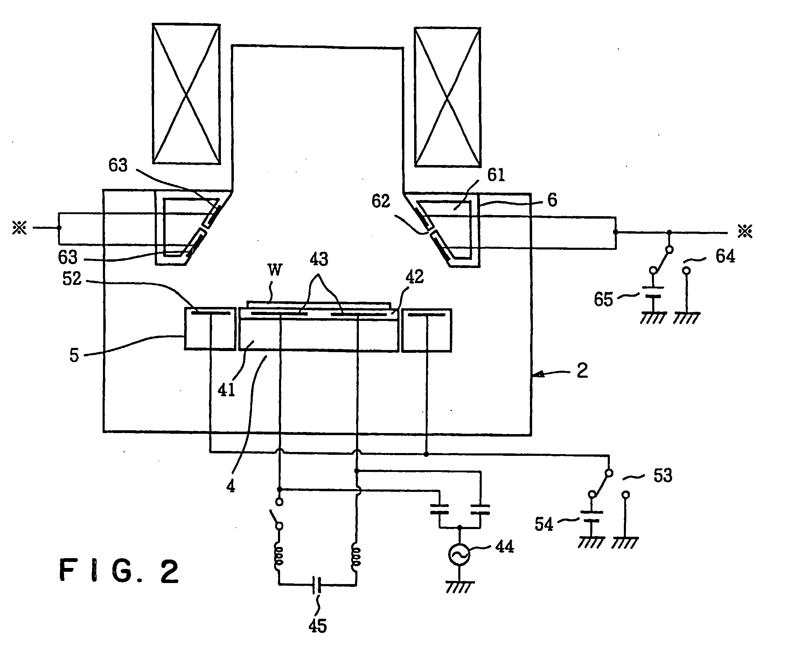

In the second vacuum chamber 22, a supporting-table 4 is provided so as to face the first vacuum chamber 21. As shown in FIG. 2, the supporting-table 4 comprises a body 41 of, e.g. aluminum, and an electrostatic chuck 42 provided on the body 41. The electrostatic chuck 42 comprises a plate of a dielectric, e.g. AlN (aluminum nitride), electrodes 43 provided thereon, and a heater (not shown) provided in the plate of the dielectric. The electrodes are connected to a high-frequency power supply 44 so as to apply a bias voltage for drawing ions into a wafer W, and to a DC power supply 45 for electrostatically absorbing the wafer W.

Around the supporting-table 4, a ring body 5 serving as a supporting-table surrounding body for surrounding the supporting-table 4 is provided. The ring body 5 is supported on a supporting leg 51 so that the top face of the ring body 5 is arranged around the supporting face of the supporting-table 4. The ring body 5 is provided for preventing a thin film from being deposited on a region below the supporting face of the supporting-table 4, i.e., on the periphery and lower portion of the supporting-table 4. The inner edge of the ring body 5 is positioned so as to define a slight gap between the ring body 5 and the supporting-table 4, and the outer edge of the ring body 5 is positioned so as to be slightly outside of a plasma-rising region and so as to prevent gas in the vacuum vessel 2 from being exhausted.

The ring body 5 is made of a material which is difficult to be etched, e.g. Al (aluminum), AlN (aluminum nitride) or Al₂O₃. As a material which is particularly difficult to be etched, aluminum nitride is preferably used. In that case, the whole ring body 5 may be made of aluminum nitride, or only the surface portion thereof may be made of aluminum nitride. In this example, the ring body 5 is made of aluminum nitride, and a particle-drawing electrode 52 of a metallic foil is embedded near the surface of the ring body 5, e.g. at a depth of 0.3 mm from the surface of the ring body 5. The electrode 52 has a ring shape so as to surround the supporting-table 4. The electrode 52 is connected to the positive potential side of a DC power supply 54, which serves as a voltage applying means, or ground, via a switching part 53.

On the other hand, as shown in FIG. 1, in the upper portion of the second vacuum chamber 22, i.e., in a portion of the second vacuum chamber 22 communicated with the first vacuum chamber 21, a ring-shaped deposition-gas supply part 6 is provided. The deposition-gas supply part 6 is formed so that a deposition-gas enters a ring-shaped gas chamber 61 from a gas supply pipe (not shown) to be jetted into the second vacuum chamber 22 via a gas hole 62 on the inner peripheral side. As shown in FIG. 2, in the inner peripheral wall of the deposition-gas supply part 6, ring-shaped particle-drawing electrodes 63 are provided so as to be exposed to the vacuum chamber 22. In this case, the particle-drawing electrodes 63 are provided in upper and lower stages so as to be arranged on both sides of the gas hole 62. The electrodes 63 are connected to the positive potential side of a DC power supply 65, which serves as a voltage applying means, or ground, via a switching part 64.

As shown in FIG. 1, near the outer periphery of the side wall defining the first vacuum chamber 21, a magnetic-field forming means, e.g. a ring-shaped main electromagnetic coil 26, is arranged. Below the second vacuum chamber 22, a ring-shaped auxiliary electromagnetic coil 27 is arranged. To the bottom of the second vacuum chamber 22, exhaust pipes 28 are connected at, e.g. two positions which are symmetrical with respect to the central axis of the vacuum chamber 22.

Referring to the block diagrams of FIGS. 1 and 2 and the flow chart of FIG. 3, a procedure for forming an interlayer dielectric film (a thin film) of, e.g. an SiO₂ film, on a wafer W serving as a substrate, on which, e.g. an aluminum wiring, has been formed, by means of the processing system with the above described construction will be described below.

First, a gate value (not shown) provided in the side wall of the vacuum vessel 2 is open, and the wafer W is introduced from a load-lock chamber (not shown) by means of a transfer arm (not shown) to be mounted on the supporting-table 4 (step S1 of FIG. 3).

Then, a microwave, a bias voltage, a electrostatic holding voltage and gases are supplied to produce plasma to carry out a thin-film deposition process on the wafer W (step S2 of FIG. 3). Specifically, a DC voltage is applied between the electrodes 43 of the electrostatic chuck 42 of the supporting-table 4 to cause the chuck 42 to electrostatically hold the wafer W. Subsequently, after the gate value is closed to seal the vacuum vessel 2, the internal atmosphere is exhausted by the exhaust pipes 28 to evacuate the interior of the vacuum vessel 2 to a predetermined degree of vacuum. Then, plasma producing gases, e.g. Ar and O₂ gases, are introduced from the gas nozzles 31 into the first vacuum chamber 21 at flow rates of, e.g. 103 sccm and 200 sccm, respectively. In addition, a deposition gas, e.g. SiH₄ gas, is introduced from the deposition-gas supply part 6 into the second vacuum chamber 22 at a flow rate of, e.g. 72 sccm. Then, the interior of the vacuum vessel 2 is held at a predetermined process pressure. The surface temperature of the supporting-table 4 is set to be about 300°C.

A microwave of 2.45 GHz and 2.0 kW from the high-frequency power supply unit 24 passes through the waveguide 25 to reach the ceiling of the vacuum vessel 2, and passes through the transmission window 23 to be introduced into the first vacuum chamber 21. By the electromagnetic coils 26 and 27, a magnetic field extending from the upper portion of the first vacuum chamber 21 toward the lower portion of the second vacuum chamber 22 is formed. In this case, the intensity of the magnetic field is, e.g. 875 gausses near the lower portion of the first vacuum chamber 21. Thus, the electron cyclotron resonance is caused by the interaction between the magnetic field and the microwave, so that Ar and O₂ gases are activated as plasma and enriched. By using Ar gas, the plasma is stabilized.

The plasma flowing from the first vacuum chamber 21 into the second vacuum chamber 22 activates SiH₄ gas, which has been supplied herein, to form active species. At this time, a bias voltage of 13.56 MHz and 1.5 kW is applied to the supporting-table 4 by means of the high-frequency power supply 44. By this bias voltage, ions are attracted to the wafer W to react with the active species and the plasma of O₂ gas to deposit a SiO₂ film on the wafer W.

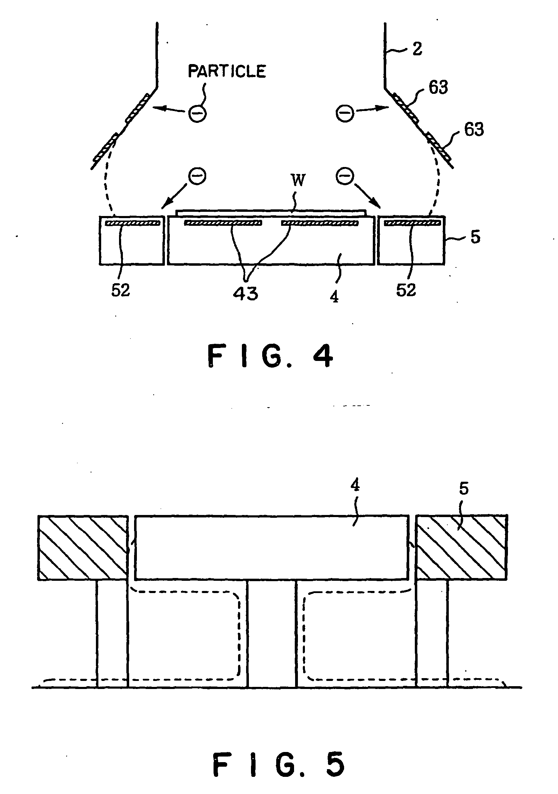

While the deposition is thus carried out, the switching parts 53 and 64 are switched to the ground, so that no voltage is applied to the particle-drawing electrodes 52 and 63. Immediately before the deposition is finished, e.g. 1 to 2 seconds before the deposition is finished, the switching parts 53 and 64 are switched to the DC power supplies 54 and 65, respectively, so that a positive voltage is applied to the particle-drawing electrodes 52 and 63 (step S3 of FIG. 3). Since the velocity of electrons in plasma is higher than that of ions therein, the number of electrons entering a material in plasma is larger than that of ions. For that reason, particles in plasma are negative-charged. Therefore, as shown in FIG. 4, the negative-charged particles are drawn into the electrodes 52 and 63 to which the positive voltage has been applied.

When the positive voltage is applied to the electrode 52 embedded in the ring body 5, the dielectric (aluminum nitride in this example) formed on the electrode 52 serves as, so to speak, a capacitor. Therefore, immediately after the positive voltage is applied to the electrode 52, the negative-charged particles are drawn into the capacitor. Thus, the particle-drawing function of the electrode 52 acts only for a short time. Therefore, the timing in applying the positive voltage to the electrode 52 is preferably immediately before the production of plasma is stopped, specifically 1 to 2 seconds before the supply of the deposition gas is stopped or before the supply of the microwave is stopped. Because, although the particles confined in plasma drop when plasma disappears, the particles are preferably drawn when the particles drop, from the point of view of the inhibition of the drop of the particles to the wafer W as greatly as possible.

Since the electrodes 63 provided in the deposition-gas supply part 6 are exposed at the beginning, the electrodes 63 always have the particle-drawing function by applying the positive voltage thereto. However, after the deposition process is repeated, a thin-film of SiO₂ is also deposited on the surface of the electrodes 63. Since this thin-film is dielectric, it serves as a capacitor. Therefore, the timing in applying the positive voltage is immediately before the production of plasma is stopped.

Then, the high-frequency power supplies 24, 44 and the DC power supply 45 are turned off to stop the production of microwaves and the application of bias and electrostatic holding voltages, and the supply of Ar, O₂ and SiH₄ gases is stopped to finish the deposition (step S4 of FIG. 3). After the deposition is finished, the switching parts 53 and 64 are switched at an appropriate point of time to connect the electrodes 52 and 63 to the ground to discharge the capacitors of the electrodes 52 and 63 (step S5 of FIG. 3).

Thereafter, the wafer W is transferred from the second vacuum chamber 22 to the load-lock chamber (not shown) (step S6 of FIG. 3). At this time, if the number of processed wafers does not reach a preset number (step S7 of FIG. 3), a deposition process is carried out on the next wafer W in the same manner (steps S1 through S6 of FIG. 3). On the other hand, if the number of processed wafers reaches the preset number (step S7 of FIG. 3), the interior of the vacuum vessel 2 is cleaned (step S8 of FIG. 3). Because it is required to prevent particles from being produced by the removing of a film since the film is deposited on the surface of the wafer W as well as on the inner wall of the vacuum vessel 2 and the surface of the ring body 5 when the film is deposited on the wafer W. Specifically, plasma is produced using, e.g. N₂ and NF₃ gases, to etch and remove the thin-film in the vacuum vessel 2.

While the cleaning (batch-cleaning) has been carried out when the number of processes has exceeded the preset number, an every-wafer-cleaning may be carried out, i.e., a cleaning may be sequentially carried out every time a deposited wafer is taken out from the vessel 2. In the latter, it is not required to carry out the step of determining whether the number of processes exceeds the preset number (step S7 of FIG. 3).

In a conventional plasma processing system having no ring body 5, a thin-film (reaction product) is deposited in regions surrounding and below the supporting-table 4 as shown by the dotted lines of FIG. 5. However, since the ring body (the supporting-table surrounding body) 5 surrounding the supporting-table is provided in this preferred system, the deposition on the region shown by the dotted lines of FIG. 5 is prevented, so that the deposition is mainly carried out on the surface of the ring body 5. Although plasma is difficult to reach the regions surrounding and below the supporting-table 4 to remove the thin-film, the surface of the ring body 5 sufficiently contacts plasma, so that the thin-film is easily removed. Since the ring body 5 is made of aluminum nitride, it is difficult to be etched and has a long life.

The top face of the ring body 5 is formed so as to have a horizontal plane in order to stabilize plasma. The reason for this is that, if the top face of the ring body 5 is inclined so as to rise, e.g. toward the inner or outer periphery, the top end on the rising side is sharp, so that there is the possibility that plasma is concentrated thereon to cause abnormal discharge.

Although particles having been confined in conductive plasma are released when the production of plasma is stopped, the released particles can be drawn into the particle-drawing electrodes 52 and 63 as described above, according to the preferred system for carrying out the method with the above described construction. Thus, it is possible to decrease the number of particles which drop to the wafer W and/or which are attracted to the wafer W. Therefore, when the wafer W is processed with plasma, it is possible to inhibit particles from adhering to the wafer W to improve yields. Since the thin-film (reaction product) is inhibited from adhering to the surrounding of the supporting-table 4, the cleaning time required to remove the thin-film is shortened, so that the cleaning efficiency is improved.

### [Results Of Experiment]

The results of a comparative experiment, which has been carried out in order to examine the effects of the present invention, will be described below.

In this experiment, a SiO₂ film was formed on a wafer having a size of about 20 cm (8 inches) on the above described process conditions, and the number of particles adhering to the surface of the wafer with the particle-drawing electrodes 52 and 63 was compared with that without the particle-drawing electrodes 52 and 63. The particles having a size of 0.2 µm or more were counted.

Specifically, when the production of plasma was stopped while the electrodes 52 and 63 were connected to the ground, i.e., without utilizing the electrodes 52 and 63, and when a positive voltage was applied to the electrodes 52 and 63 one second before the production of plasma was stopped, experiments were carried out. When a positive voltage was applied to the electrodes 52 and 63, experiments were carried out with respect to two kinds of voltages of 0.6 kV and 1.0 kV.

As a result, when the particle-drawing electrodes 52 and 63 were not utilized, the number of the particles exceeded 50. On the other hand, when a positive voltage of 0.6 kV or 1.0 kV was applied, the number of the particles was 10 or less. Therefore, it was validated that the particles were inhibited from adhering to the wafer according to the above described preferred embodiment.

According to the present invention, the particle-drawing electrodes may be provided on the inner wall of the vacuum vessel 2, or exposed to the surface of the ring body 5 without being embedded. While the ring body 5 has been used as the supporting-table surrounding body, an member having another shape may be used as long as it surrounds the supporting-table 4.

The plasma producing system used for the process should not be limited to the above described ECR. The plasma process should not be limited to the above described thin-film deposition process. For example, the plasma process may be applied to etching or the like. For example, when etching is carried out, even if the particle-drawing electrodes are exposed in the vacuum vessel, no deposition is carried out on the surface thereof. Therefore, the positive voltage to the electrodes must be applied immediately before the production of plasma is stopped.

### [Preferred Construction Of Supporting-table for use in a method as claimed]

A preferred structure of the supporting-table 4 will be described below.

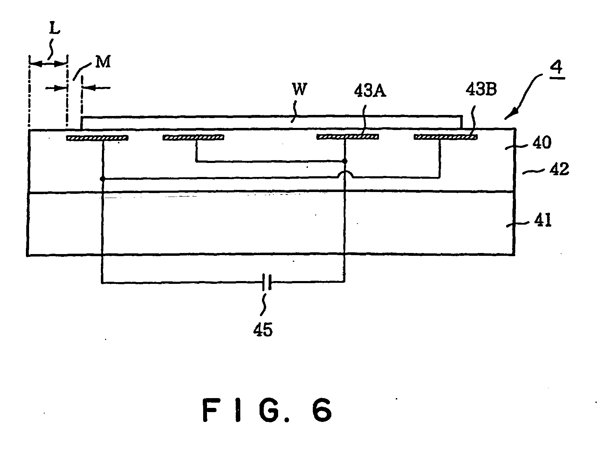

The body 41 of the supporting-table 4 shown in FIG. 6 forms a cooling jacket in which a refrigerant passage (not shown) is formed. Therefore, although the wafer W is heated when plasma is produced, this heat is radiated to the body 41 via the electrostatic chuck 42. Since the wafer W is put in a vacuum atmosphere, the degree of radiation is controlled by the degree of contact of the wafer W with the surface of the electrostatic chuck 42. Therefore, the temperature of the wafer W can be controlled by, e.g. adjusting the holding force of the electrostatic chuck 42.

In the example of FIG. 6, the electrostatic holding electrode 43 comprises a ring-shaped electrode 43A arranged inside, and a ring-shaped electrode 43B concentrically outside of the electrode 43A. A DC voltage is applied between the electrodes 43A and 43B by the DC power supply 45 (circuit portions are simply shown). The outer edge of the outside electrode 43B is arranged outside of the outer edge of the wafer W by 2 mm or more, e.g. 3 mm. In other words, the outside diameter of the outside electrode 43B is greater than the diameter of the wafer W by 4 mm or more. That is, the dimension M in FIG. 6 is 2 mm or more.

If the supporting-table 4 is thus constructed, there are the following advantages. In order to form the electrostatic chuck, the outside of the surface of the dielectric 40 is slightly lower due to the constructing process. Therefore, the outer edge of the electrode 43 (the outer edge of the outside electrode 43B in the above described example) is arranged outside of the wafer W, so that a sufficient holding force is also applied to the outer edge of the wafer W. Thus, the holding between the wafer W and the electrostatic chuck 42 is uniformly carried out over the whole surface of the wafer W, so that the heat of the whole surface of the wafer W is uniformly radiated. Thus, as compared with a case where the outer edge of the electrode 43 is arranged inside of the wafer W, it is possible to insure a high in-plane-temperature-uniformity up to the outer edge of the wafer W. Therefore, even if a device intended region on the wafer is extended outward, patterns can be suitably embedded.

With respect to a wafer W having a size of about 20 cm (8 inches) experiments on the filling of a groove, having a width of 0.8 µm, with SiO₂ were carried out by varying the outside diameter of the electrode 43. As a result, when the extrusion dimension M (FIG. 6) of the electrode 43 with respect to the wafer W was -3mm (the outer edge of the electrode 43 was arranged inside of the outer edge of the wafer W) and 0 mm, grooves capable of being filled had aspect ratios of 1 and 2, respectively. On the other hand, when the dimension M was 3 mm or more, a groove capable of being filled had aspect ratios of 3.

It is considered that this result is based on the fact that if the outer diameter of the electrode 43 is that of the wafer W or less, the electrostatic holding force of the outer edge portion of the wafer W is weakened to deteriorate the heat radiation of the wafer W to deteriorate the embedding characteristics of patterns.

The outer edge of the dielectric 40 is preferably arranged outside of the outer edge of the electrode 43, and its extrusion dimension L (FIG. 6) is preferably 30 mm or more. The reason for this is that electric fields are concentrated on the corners of the outer edge of the top face of the dielectric 40 to cause abnormal discharge to cause the production of particles, since a portion of the dielectric 40 outside of the electrode 43 serves as a capacitor. That is, the outer edge of the dielectric 40 is spaced from the electrode 43 to moderate the concentration of electric fields, so that it is difficult to cause abnormal discharge.

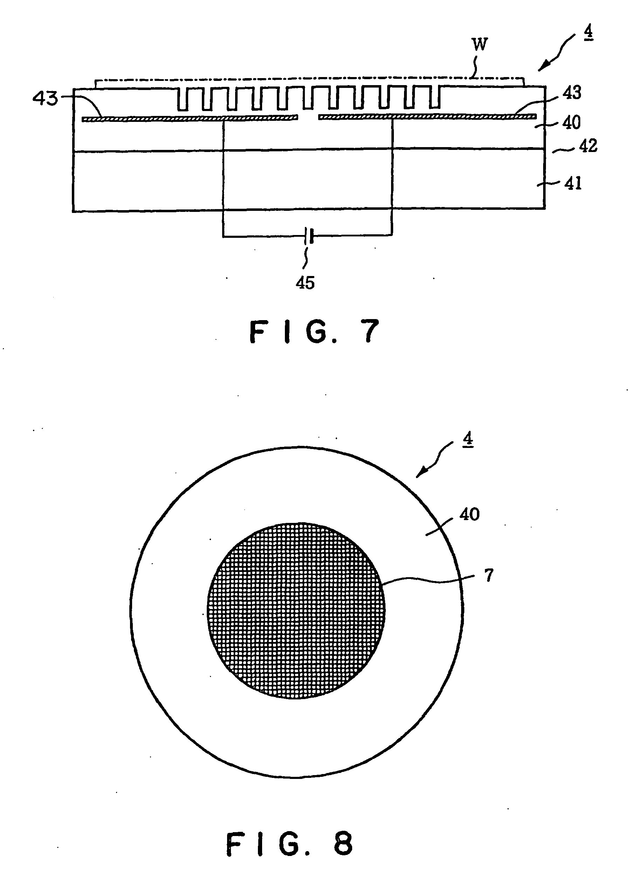

FIGS. 7 and 8 show another example of a supporting-table 4. In this example, irregularities are formed in the central portion of the surface of the dielectric 40, and no irregularities are formed on the peripheral portion of the surface of the dielectric 40 so that the whole surface of the wafer W contacts the dielectric. In FIG. 7, although the actual depth of a recessed portion (groove) is set to be, e.g. about 50 µm, the depth of the groove is enlarged in the figure for convenience. In FIG. 8, a circular region (reference number 7) shown by mesh in the central portion corresponds to a region on which the irregularities are formed in FIG. 7. Assuming that this region is called an irregularity region 7, the diameter of the dielectric 40 is 205 mm and the diameter of the irregularity region 7 is 150 mm in the case of a supporting-table for an 8-inch (about 20 cm) wafer.

When the supporting-table 4 is thus constructed, the advantages will be described below.

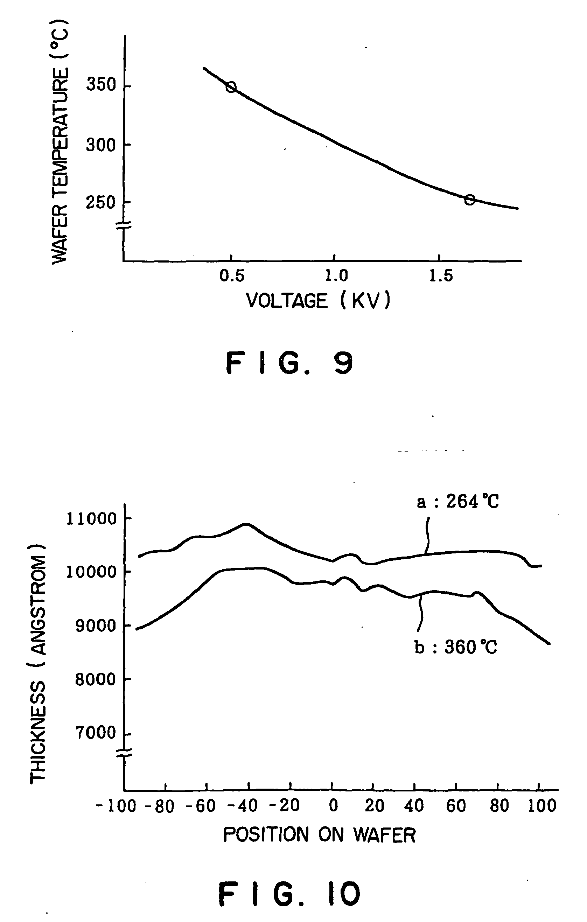

For example, in order to improve the quality of an interlayer dielectric film, it has been studied that an SiOF film is substituted for the SiO₂ film. When an SiOF film is deposited by an ECR system using SiF₄ and O₂ gases, a process temperature is, e.g. 350 °C, which is higher than the process temperature (e.g. 250 °C) when an SiO₂ film is deposited. As described above, the temperature of the wafer W is controlled by, e.g. adjusting the holding force of the electrostatic chuck 42. To raise the temperature of the wafer W is to weaken the holding force of the electrostatic chuck 42, i.e., to lower the voltage applied between the electrodes 43 and 43. FIG. 9 schematically shows an example of the relationship between the electrostatically holding voltage, i.e., the voltage applied between the electrodes 43 and 43, and the temperature of the wafer W. In the example shown in FIG. 9, the voltage is lowered from 1.6 kV to 0.5 kV in order to raise the wafer temperature from 250 °C to 350 °C.

As described above, the height of the periphery of the dielectric 40 tends to lower, and the wafer W is slightly curved. Therefore, if the holding force of the whole electrostatic chuck 42 is weaken, the degree of the face contact in the peripheral portion of the wafer W particularly decreases. For that reason, the temperature of the peripheral portion of the wafer W is higher than that of the central portion thereof, so that the inplane uniformity of the thickness of the film deteriorates.

FIG. 10 shows the examined results of the relationship between the position of an SiO₂ film on a wafer (the distance from the center) and the thickness of the film when the SiO₂ film was deposited on a typical supporting-table at process temperatures of (a) 264 °C and (b) 360 °C. From the results, it can be seen that in the case of (b) the higher process temperature, the thickness of the peripheral portion of the wafer is smaller than that of the central portion thereof, and the temperature of the peripheral portion is higher (because the deposition rate and the thickness decrease as the temperature rises in this thin-film deposition process).

Therefore, if the contact area of the peripheral portion of the wafer W with the supporting-table 4 is greater than that of the central portion as this example, the degrees of contact of the peripheral and central portions of the wafer W with respect to the surface of the supporting-table 4 (the dielectric 42) can be the same. As a result, a uniform heat transfer can occur on the whole surface of the wafer W. Therefore, the inplane uniformity of the temperature of the wafer W can be enhanced, so that the inplane uniformity of the film-thickness on the wafer W can be improved.

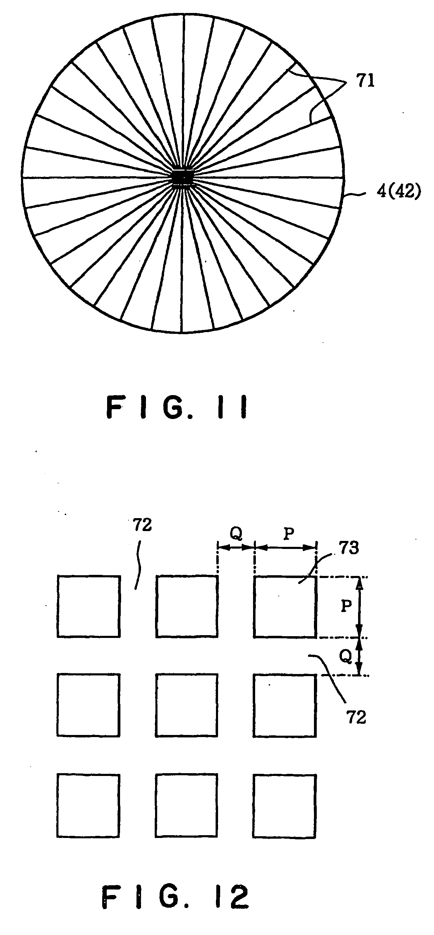

As an example of such a supporting-table 4, radial grooves 71 extending from the central portion of the supporting-table 4 (the dielectric 42) toward the periphery thereof may be formed as shown in FIG. 11 so that the contact area of the peripheral portion is greater than that of the central portion. In accordance with conditions, the contact area of the peripheral portion of the wafer W may be smaller than that of the central portion thereof contrary to the above described example.

If irregularities are formed on the surface of the wafer W, there is an advantage in that the wafer W can be easily detached from the electrostatic chuck 42 in addition to the advantage that the contact area can be controlled as describfed above. Therefore, with respect to the former advantage, irregularities may be formed on the surface of the supporting-table 4 so that the contact area is uniform on the surface of the wafer W. In that case, for example, square protrusions 73 may be formed as islands by forming lattice-like grooves 72 as shown in FIG. 12. As an example, the length P of one side of the square protrusions 73 is 1.8 mm, the width Q of the groove 72 is 1.2 mm, and the depth of the groove 72 is 0.5 mm.

## Claims

1. A method of processing a substrate in a plasma processing system comprising a vacuum vessel and a supporting-table (4), provided in the vacuum vessel (2), for supporting thereon the substrate (W) and a particle-drawing electrode (52) provided in said vacuum vessel (2); wherein a process gas is supplied to the vacuum vessel to produce a plasma of the process gas to carry out a process with respect to the substrate (W), which is supported on the supporting-table (4), with the plasma of the process gas, and a positive voltage is applied to said particle-drawing electrode (52) when the production of said plasma is stopped, **characterised in that** the application of said voltage to said particle-drawing electrode is started immediately before the production of said plasma is stopped.

2. The method of claim 1 , wherein said process carried out with respect to the substrate (W) with the plasma is a thin-film deposition process.

3. The method of claim 1 , wherein said process carried out with respect to the substrate (W) with the plasma is an etching process.

4. The method of one of the preceding claims, wherein the application of said voltage to said particle-drawing electrode is started when the supply of said process gas is stopped.

5. The method of one of the preceding claims, wherein said vacuum vessel (2) comprises a first vacuum chamber (21) for producing a plasma therein by utilizing a high frequency, and a second vacuum chamber (22) communicated with said first vacuum chamber (21); including the steps of:
supplying said high frequency to said first vacuum chamber (21);
supplying said process gas to said second vacuum chamber (22); and
supporting a substrate (W) in said second vacuum chamber (22),
wherein said plasma of said process gas is produced in said second vacuum chamber (22) to carry out a process with respect to said substrate (W) on said supporting-table (2) with said plasma of said process gas.

6. The method of claim 5, wherein said process gas is jetted into said second vacuum chamber (22).

7. The method of claim 5 or 6, wherein the application of said voltage to said particle-drawing electrode (52) is started immediately before the supply of said high frequency is stopped.

## Patentansprüche

1. Verfahren zum Verarbeiten eines Substrats in einem Plasmaverarbeitungssystem mit einem Vakuumgefäß und einer Auflagetisch (4), der in dem Vakuumgefäß (2) vorgesehen ist, zum Halten des Substrats (W) darauf und einer Partikel-Ansaugelektrode (52), die in dem Vakuumgefäß (2) vorgesehen ist, wobei ein Prozeßgas in das Vakuumgefäß eingeleitet wird, um ein Plasma des Prozeßgases zu erzeugen, um ein Prozeß in Bezug auf das Substrat, das von dem Auflagetisch (4) getragen wird, mit dem Plasma des Prozeßgases auszuführen, und eine positive Spannung an die Partikel-Ansaugelektrode (52) angelegt wird, wenn die Erzeugung des Plasmas beendet wird, **dadurch gekennzeichnet, daß** mit dem Anlegen der Spannung an die Partikel-Ansaugelektrode begonnen wird, unmittelbar bevor die Erzeugung des Plasmas beendet wird.

2. Verfahren nach Anspruch 1, wobei der Prozeß, der mit dem Plasma in Bezug auf das Substrat (W) ausgeführt wird, ein Dünnfilm-Abscheideprozeß ist.

3. Verfahren nach Anspruch 1, wobei der Prozeß, der mit dem Plasma in Bezug auf das Substrat (W) ausgeführt wird, ein Ätzprozeß ist.

4. Verfahren nach einem der vorangehenden Ansprüche, wobei mit dem Anlegen der Spannung an die Partikel-Ansaugelektrode begonnen wird, wenn die Zuführung des Prozeßgases gestoppt wird.

5. Verfahren nach einem der vorangehenden Ansprüche, wobei das Vakuumgefäß (2) eine erste Vakuumkammer (21) zum Erzeugen eines Plasma darin unter Verwendung einer Hochfrequenz und eine zweite Vakuumkammer (22), die mit der ersten Vakuumkammer (21) in Verbindung steht, aufweist, mit den weiteren Verfahrensschritten:
Zuführen der Hochfrequenz zu der ersten Vakuumkammer (21);
Zuführen des Prozeßgases zu der zweiten Vakuumkammer (22); und
Halten eines Substrats (W) in der zweiten Vakuumkammer (22),
wobei das Plasma des Prozeßgases in der zweiten Vakuumkammer (22) erzeugt wird, um in Bezug auf das Substrat (W) auf dem Auflagetisch (2) mit dem Plasma des Prozeßgases ein Prozeß auszuführen.

6. Verfahren nach Anspruch 5, wobei das Prozeßgas in die zweite Vakuumkammer (22) eingespritzt wird.

7. Verfahren nach Anspruch 5 oder 6, wobei mit dem Anlegen der Spannung an die Partikel-Ansaugelektrode (52) begonnen wird, unmittelbar bevor die Zuführung der Hochfrequenz gestoppt wird.

## Revendications

1. Procédé pour traiter un substrat dans un système de traitement au plasma comprenant un réservoir de vide, et un plateau de support (4) prévu dans le réservoir de vide (2), pour supporter sur lui le substrat (W), et une électrode d'attraction de particules (52) prévue dans ledit réservoir de vide (2) ; dans lequel un gaz de travail est envoyé vers le réservoir de vide pour produire un plasma du gaz de travail en vue d'exécuter un processus par rapport au substrat (W), qui est supporté sur le plateau de support (4), avec le plasma du gaz de travail, et une tension positive est appliquée sur ladite électrode d'attraction de particules (52) quand la production dudit plasma est arrêtée, **caractérisé en ce que** l'application de ladite tension sur ladite électrode d'attraction de particules débute immédiatement avant que la production dudit plasma ne soit arrêtée.

2. Procédé selon la revendication 1, dans lequel ledit processus réalisé par rapport au substrat (W) avec le plasma est un processus de dépôt de couches minces.

3. Procédé selon la revendication 1, dans lequel ledit processus réalisé par rapport au substrat (W) avec le plasma est un processus de gravure.

4. Procédé selon l'une des revendications précédentes, dans lequel l'application de ladite tension sur ladite électrode d'attraction de particules débute quand la fourniture dudit gaz de travail est arrêtée.

5. Procédé selon l'une des revendications précédentes, dans lequel ledit réservoir de vide (2) comprend une première chambre à vide (21) pour produire un plasma à l'intérieur d'elle en utilisant une haute fréquence, et une deuxième chambre à vide (22) en communication avec ladite première chambre à vide (21) ; le procédé comprenant les étapes consistant à :
fournir ladite haute fréquence à ladite première chambre à vide (21) ;
fournir ledit gaz de travail à ladite deuxième chambre à vide (22) ; et
supporter un substrat (W) dans ladite deuxième chambre à vide (22),
dans lequel ledit plasma dudit gaz de travail est produit dans ladite deuxième chambre à vide (22) pour exécuter un processus par rapport au dit substrat (W) sur ledit plateau de support (2) avec ledit plasma dudit gaz de travail.

6. Procédé selon la revendication 5, dans lequel ledit gaz de travail est projeté par jets à l'intérieur de ladite deuxième chambre à vide (22).

7. Procédé selon la revendication 5 ou 6, dans lequel l'application de ladite tension sur ladite électrode d'attraction de particules (52) débute immédiatement avant que la fourniture de ladite haute fréquence ne soit arrêtée.
